# EUROPÄISCHE PATENTSCHRIFT

(11) **EP 1 348 232 B1**
(45) Veröffentlichungstag und Bekanntmachung des Hinweises auf die Patenterteilung: **23.05.2007**
(21) Anmeldenummer: 01995583.0
(22) Anmeldetag: 06.12.2001
(51) Int. Cl.: H01L 21/28, H01L 21/285, H01L 21/768

(54) **VERFAHREN ZUR KONTAKTIERUNG EINES DOTIERGEBIETS EINES HALBLEITERBAUELEMENTS**
METHOD FOR CONTACTING A DOPING AREA ON A SEMICONDUCTOR ELEMENT
PROCEDE D'ETABLISSEMENT DES CONTACTS D'UNE ZONE DOPEE D'UN COMPOSANT A SEMI-CONDUCTEUR

(30) Priorität: 04.01.2001 DE 10100178
(43) Veröffentlichungstag der Anmeldung: 01.10.2003
(73) Patentinhaber: Infineon Technologies AG, 81669 München (DE)
(72) Erfinder: RUF, Alexander, 01277 Dresden (DE); URBANSKY, Norbert, 01159 Dresden (DE); CLAUSSEN, Wilhelm, 01129 Dresden (DE); GÄRTNER, Thomas, 01458 Ottendorf-Okrilla (DE); SCHMIDBAUER, Sven, 01099 Dresden (DE)
(74) Vertreter: Epping - Hermann - Fischer
(86) Internationale Anmeldenummer: PCT/DE2001/004590
(87) Internationale Veröffentlichungsnummer: WO 2002/054470

(56) Entgegenhaltungen:
- US-A- 4 701 349
- US-A- 5 639 678
- US-A- 6 121 134

## Beschreibung

Die vorliegende Erfindung betrifft ein Verfahren zur Kontaktierung eines Dotiergebiets eines Halbleiterbauelements.

Halbleiterbauelemente werden beispielsweise in einem Siliziumsubstrat gebildet. In dem Halbleitersubstrat werden dazu unter anderem Kondensatoren, Widerstände oder Transistoren gebildet. Weiterhin werden in dem Halbleitersubstrat leitfähige Gebiete erzeugt, indem Dotierstoff in das Halbleitersubstrat eingebracht wird. Die dotierten Gebiete weisen eine erhöhte Leitfähigkeit auf und werden als elektrische Anschlüsse für die in dem Halbleitersubstrat gebildeten Bauelemente verwendet. In nachfolgenden Prozessierungsschritten werden unterschiedliche Dotiergebiete mittels Leiterbahnen elektrisch miteinander verbunden.

Die elektrische Verdrahtung wird üblicherweise so gebildet, daß zunächst eine isolierende Schicht auf einer Oberfläche des Halbleitersubstrats abgeschieden wird und in der isolierenden Schicht anschließend Kontaktlöcher gebildet werden. Die Kontaktlöcher erstrecken sich üblicherweise von der Oberfläche der isolierenden Schicht bis zu einer Oberfläche eines anzuschließenden dotierten Gebiets, wobei die Oberfläche des anzuschließenden dotierten Gebiets mittels des Kontaktlochs freigelegt ist. Anschließend wird beispielsweise eine metallhaltige Schicht auf der isolierenden Schicht und in dem Kontaktloch auf dem Dotiergebiet abgeschieden. Nachfolgend wird üblicherweise ein Temperaturschritt in stickstoffhaltiger Atmosphäre durchgeführt, bei dem zwei Prozessziele gleichzeitig erreicht werden. Erstens reagiert ein Teil der metallhaltigen Schicht mit dem Silizium des Dotiergebiets zu einer Silizidschicht und zweitens reagiert der nicht silizierte Teil der metallhaltigen Schicht zu einer metall-nitrid-haltigen Schicht.

Die oben angegebenen Verfahrensschritte sind beispielsweise bekannt aus "Nitridation of Polycrystalline Titanium as Studied by in situ Anegl -resolved X-ray Photoelectron spectroscopy", A. Ermolieff et al., Surface and Interface Analysis, Vol. 11, p. 563-568 (1988); aus "influence of the sputtering method of TiN/Ti films on the resistance of high aspect ratio contact holes", R. Kanamura et al., VMIC Conference Abstracts, p. 554-559 (1996); aus "Tungsten Contacts for 256M DRAM process using a thermally formed TiN diffusion barrier", J. Gambino et al., VMIC Conference Abstracts, p. 180i-180k (1996); aus "Ion Metal Plasma (IMP) deposited titanium liners for 0.25 and 0.18 µm multilevel interconnects", Proceedings of IEEE International Electron Devices Meeting, (1996) und aus "Integrated IMP Ti and MOCVD TiN for 300 mm W Barrier and Liners for Sub 0.18 µm IC Processing", Proceedings of SPIE, Volume 3883, p. 130-136, (1999) bekannt.

Nachteilig bei den bekannten Verfahren ist allerdings, daß der Widerstand am Boden des Kontaktlochs relativ hochohmig ausgebildet ist. Dies ist bedingt durch die stetig abnehmenden Strukturbreiten in der Halbleiterindustrie und dem damit verbundenen Ansteigen des Aspektverhältnisses des Kontaktlochs, welches das Verhältnis aus Kontaktlochtiefe zu Kontaktlochdurchmesser quantifiziert.

Ein Nachteil des Standes der Technik besteht darin, daß die gebildete Silizidschicht eine zu geringe Dicke aufweist und somit der elektrische Widerstand beim Kontaktieren des Dotiergebiets relativ groß ausgebildet wird. Dies führt beispielsweise bei der Laufzeit von elektrischen Signalen zu nicht tolerierbaren Verzögerungszeiten, wodurch die elektrische Schaltung und das Bauelement unbrauchbar werden.

In der US-A-4 701 349 ist ein Verfahren beschrieben, um ein Dotierungsgebiet eines Transistors zu kontaktieren. Hierzu wird auf dem Dotierungsgebiet des Transistors eine Metallschicht, beispielsweise Titan, abgeschieden und in N₂- oder Ar-Atmoshpäre bei etwa 500 °C geglüht. Es entsteht eine Titansilizidschicht. Anschließend erfolgt ein weiteres Glühen in Stickstoffatmosphäre, so dass Titannitrid gebildet wird.

In der US-A-5 639 678 ist ein Verfahren zur Kontaktierung eines Dotierungsgebiets eines Transistors beschrieben, bei dem gesputtertes Titan unter Argon- oder Neon-Gas einer Wärmebehandlung bei 600 °C bis 700 °C unterzogen wird, um Titansilizid zu erhalten. Anschließend wird das Substrat bei etwa 700 °C einer NH₃-Atmosphäre ausgesetzt, um Titannitrid zu bilden.

Es ist die Aufgabe der Erfindung ein verbessertes Verfahren zur Kontaktierung eines Dotiergebiets eines Halbleiterbauelements anzugeben.

Erfindungsgemäß wird die Aufgabe gelöst durch ein Verfahren zur Kontaktierung eines Dotiergebiets eines Halbleiterbauelements mit den Schritten: Einbringen von Dotierstoff in ein Siliziumsubstrat mit einer Substratoberfläche, wobei ein Dotiergebiet an der Substratoberfläche in dem Substrat gebildet wird; Abscheiden und Strukturieren einer isolierenden Schicht auf der Substratoberfläche, wobei ein Oberflächenbereich des Dotiergebiets freigelegt wird; Abscheiden einer metallhaltigen Schicht auf der isolierenden Schicht und dem Oberflächenbereich; Prozessieren des Substrats während eines ersten Schritts in einer Prozeßkammer bei einer ersten Temperatur in einer ersten Atmosphäre, die H₂ enthält, für eine erste Zeitdauer, so daß aus einem Teil der metallhaltigen Schicht und einem Teil des Dotiergebiets Metallsilizid entsteht; und nachfolgend Prozessieren des Substrats während eines zweiten Schritts bei einer zweiten Temperatur in einer zweiten Atmosphäre, die H₂ und N₂ enthält, für eine zweite Zeitdauer, um einen verbleibenden anderen Teil der metallhaltigen Schicht zu Metallnitrid umzuwandeln, wobei der N₂-Anteil in der zweiten Atmosphäre größer ist als in der ersten Atmosphäre.

Erfindungsgemäß werden zwei Temperaturschritte durchgeführt, wobei der erste Temperaturschritt dazu geeignet ist, zunächst einen Teil der abgeschiedenen metallhaltigen Schicht mit dem Silizium des Dotiergebiets zu einer Silizidschicht zu verreagieren, die einen niederohmigen Kontakt zu dem Dotiergebiet ermöglicht. Die jeweilige erste und zweite Atmosphäre während der zwei Temperaturschritte enthält das inerte Gas H₂. Wasserstoff weist beispielsweise die positive Eigenschaft auf, daß Störstellen in einem Substrat während einer Wasser-Stofftemperierung ausgeheilt werden können. Durch den erhöhten Stickstoffanteil während des zweiten Temperaturschritts in der zweiten Atmosphäre wird der verbleibende Teil der metallhaltigen Schicht in eine metall-nitrid-haltige Schicht umgewandelt. Die metall-nitridhaltige Schicht weist dabei den Vorteil auf, daß sie als Diffusionsbarierre für Dotierstoffe und Verunreinigungen wirkt. Ebenso wirkt sie als Diffusionsbarierre für reaktive Gase bei nachfolgenden Schritten wie einer Wolframabscheidung oder als Diffusionsbarierre für Metallschichten mit einer hohen Diffusion in Silizium wie beispielsweise Aluminium.

Ein weiterer Vorteil des erfindungsgemäßen Verfahren besteht darin, daß die Dicke der gebildeten Silizidschicht und die Dicke der gebildeten metall-nitrid-haltigen Schicht mittels der zwei unabhängigen Temperaturschritte unabhängig voneinander eingestellt werden kann. Dies erhöht die Prozeßflexibilität und ermöglicht einen verringerten elektrischen Widerstand bei der Kontaktierung des Dotiergebiets.

Eine vorteilhafte Ausgestaltung des erfindungsgemäßen Verfahrens sieht vor, daß die erste Zeitdauer kürzer ist als die zweite Zeitdauer.

Ein weiterer Verfahrensschritt sieht vor, daß die metallhaltige Schicht Titan, Tantal, Kobalt, Molybdän, Palladium, Platin, Nickel oder Wolfram enthält. Diese Metalle sind dazu geeignet, eine Metallsilizidschicht zu bilden.

Weiterhin ist vorgesehen, daß die metallhaltige Schicht mittels eines ionisierten Metallplasmaverfahrens - bei einer Temperatur zwischen 180°C und 220°C und bevorzugt bei 200°C - abgeschieden wird. Ionisierte Metallplasma Abscheideverfahren sind in vorteilhafter Weise dazu geeignet, Metallionen mittels des gerichteten Verfahrens auf dem Boden eines Kontaktlochs mit einem großen Aspektverhältnis abzuscheiden. Folglich wird die metallhaltige Schicht auf dem Oberflächenbereich des Dotiergebiets mit einer erhöhten Schichtdicke und einer verbesserten Konformität abgeschieden. Dies führt in vorteilhafter Weise zu einem verringerten Kontaktwiderstand.

Weiterhin ist vorgesehen, daß der freigelegte Oberflächenbereich mittels einer naßchemischen Reinigung gereinigt wird. Die naßchemische Reinigung hat den vorteil, daß evtl. vorhandene isolierende Schichten von dem Oberflächenbereich des Dotiergebiets entfernt werden. Hierdurch wird ein verringerter Kontaktwiderstand erreicht.

Weitere vorteilhafte Ausgestaltungen der Erfindung sind Gegenstand der jeweiligen Unteransprüche.

Nachfolgend wird die Erfindung anhand von Ausführungsbeispielen und Figuren näher erläutert.

In den Figuren zeigen:
- Figur 1: ein Substrat mit einem Dotiergebiet, einem Kontaktloch und einer metallhaltigen Schicht;
- Figur 2: die Anordnung aus Figur 1, wobei eine Metallsilizidschicht gebildet wurde;
- Figur 3: die Anordnung gemäß Figur 2, wobei die metallhaltige Schicht in eine metall-nitrid-haltige Schicht umgewandelt wurde;
- Figur 4: den relativen Widerstand der Kontaktierung eines Dotiergebiets für vier unterschiedliche Herstellungsverfahren.

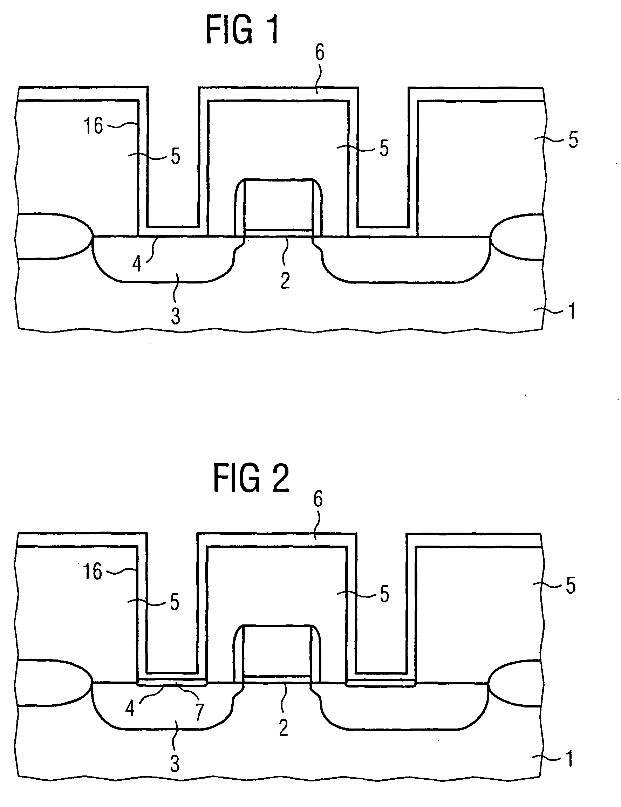

In Figur 1 ist ein Substrat 1 mit einer Substratoberfläche 2 dargestellt. In dem Substrat 1 ist an der Substratoberfläche 2 ein Dotiergebiet 3 angeordnet. Auf der Substratoberfläche 2 ist eine isolierende Schicht 5 angeordnet. In der isolierenden Schicht 5 ist ein Kontaktloch 16 gebildet. Das Kontaktloch 16 legt einen Oberflächenbereich 4 des Dotiergebiets 3 frei. Auf der isolierenden Schicht 5 und dem freigelegten Oberflächenbereich 4 ist eine metallhaltige Schicht 6 angeordnet.

Ein Verfahren zur Bildung der in Figur 1 dargestellten Anordnung bildet zunächst mittels einer Implantation das Dotiergebiet 3 in dem Substrat 1. Dazu wird beispielsweise Dotierstoff durch die Substratoberfläche 2 hindurch in das Substrat 1 eingebracht, was beispielsweise mittels einer Ionenimplantation durchgeführt werden kann. Nachfolgend wird die isolierende Schicht 5 beispielsweise mit einem CVD-Verfahren (Chemical Vapour Deposition) abgeschieden. Beispielsweise handelt es sich bei der isolierenden Schicht 5 um ein dotiertes Silikatglas wie BPSG (Bor Phosphor Silikat Glas). Das Dotiergebiet 3 kann n-leitend oder p-leitend ausgebildet sein, abhängig von den verwendeten Dotierstoffen. Als Dotierstoffe sind beispielsweise Bor, Phosphor und Arsen geeignet. Das Substrat 1 kann ebenfalls als p- bzw. n-dotiertes Substrat ausgebildet sein. Ein nachfolgender Verfahrensschritt bildet mittels eines photolithographischen und eines Ätzschrittes eine Maske auf der isolierenden Schicht 5, die zur Strukturierung der isolierenden Schicht 5 geeignet ist. Die Maske kann aus einem Siliziumnitrid gebildet sein. Das Kontaktloch wird nachfolgend mittels eines gerichteten Ätzverfahrens in die isolierende Schicht 5 hineingeätzt. Dabei wird das Kontaktloch 16 so weit in die isolierende Schicht 5 hinein gebildet, daß der Oberflächenbereich 4 des Dotiergebiets 3 freigelegt ist. Nachfolgend wird ein Reinigungsschritt zur Reinigung des Oberflächenbereichs 4 durchgeführt. Hierzu ist ein naßchemisches und isotropes Ätzverfahren geeignet. Nachfolgend wird eine metallhaltige Schicht 6 auf der isolierenden Schicht 5 und dem freigelegten Oberflächenbereich 4 mittels einer ionisierten Metallplasma Abscheidung gebildet. Dabei handelt es sich um ein plasmaunterstütztes Sputter-Verfahren, bei dem ionisierte Metallpartikel mit einer gerichteten Komponente auf dem Oberflächenbereich 4 des Dotiergebiets 3 abgeschieden werden. Der ionisierte Metallplasma-Prozeß wird beispielsweise bei einer Temperatur von 200°C durchgeführt.

Mit Bezug auf Figur 2 ist eine Metallsilizidschicht 7 zwischen dem Dotiergebiet 3 und der metallhaltigen Schicht 6 gebildet. Die Metallsilizidschicht 7 wird in einer Prozeßkammer bei einer ersten Temperatur 10 in einer ersten Atmosphäre 11 für eine erste Zeitdauer 12 gebildet. Falls die metallhaltige Schicht 6 Titan enthält, so ist ein Prozeß bei einer Temperatur von 550°C in einer wasserstoffhaltigen Atmosphäre mit einer Zeitdauer von 5 Minuten dazu geeignet, die Metallsilizidschicht 7 als Titansilizidschicht zu bilden. Vorteilhafterweise wird dabei der Stickstoffanteil der Atmosphäre gering gehalten. Vorzugsweise ist der Stickstoffanteil unter 25%.

Weiterhin ist ein Prozeßschritt in einem RTP-Ofen (Rapid Thermal Processing) dazu geeignet, die Metallsilizidschicht 7 zu bilden. Dazu wird das Substrat bei einer Temperatur von 600°C in wasserstoffhaltiger Atmosphäre für 10 Sekunden erhitzt.

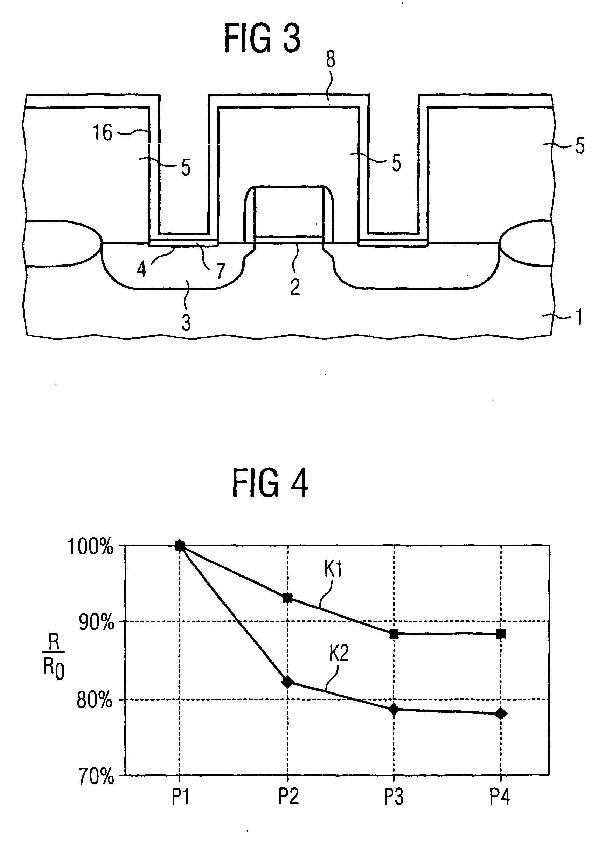

Mit Bezug auf Figur 3 ist die metallhaltige Schicht 6 in eine metall-nitrid-haltige Schicht 8 umgewandelt worden. Dies wird erreicht, indem das Substrat in einer Prozeßkammer bei einer zweiten Temperatur in einer zweiten Atmosphäre für eine zweite Zeitdauer prozessiert wird. Handelt es sich bei der metallhaltigen Schicht 6 um eine titanhaltige Schicht, so kann bei einer Temperatur von 550°C in einer Formiergasatmosphäre mit 4% Wasserstoff und 96% Stickstoffanteil bei einer Zeitdauer von 20 Minuten eine titan-nitrid-haltige Schicht 8 gebildet werden. Weiterhin ist ein RTP-Prozeßschritt bei einer Temperatur von 600°C in Formiergasatmosphäre mit 4% Wasserstoff und 96% Stickstoffanteil für eine zweite Zeitdauer von 50 Sekunden dazu geeignet, eine titan-nitrid-haltige Schicht 8 zu bilden.

Weiterhin ist ein Temperaturschritt in einer Prozeßkammer bei einer Temperatur von 550°C in einer Atmosphäre mit 10% Wasserstoff und 90% Stickstoff für eine Zeitdauer von 25 Minuten dazu geeignet, eine Titansilizid- und eine Titannitridschicht zu bilden.

In Figur 4 ist der relative Widerstand für vier unterschiedliche Prozessierungsverfahren P1,P2,P3 und P4 für jeweils zwei unterschiedliche Sputter-Verfahren zur Bildung der metallhaltigen Schicht 6 dargestellt. Die erste Kurve K1 verbindet die Sputter-Abscheideverfahren für die metallhaltige Schicht, die mittels einer ionisierten Metallplasma-Abscheidung gebildet worden sind. Die Kurve K2 verbindet Punkte, bei denen die metallhaltige Schicht 6 mit einem Standard-Sputter-Verfahren gebildet wurde.

Das Verfahren P1 führt einen einschrittigen Temperaturschritt bei einer Temperatur von 550°C in einer Atmosphäre mit 4% Wasserstoff und 96% Stickstoff für eine Zeitdauer von 25 Minuten durch. Dabei zeigt sich, daß die Kurve K1 und die Kurve K2 den gleichen Widerstandswert ergeben. Als Vergleichsbasis für die anderen Prozeßführungen P2 bis P4 wird der Widerstand der Prozeßführung P1 als Referenzwert mit 100% verwendet.

Die Prozeßführung P2 führt zunächst einen ersten Temperaturschritt für 10 Minuten in wasserstoffhaltiger Atmosphäre bei 550°C durch. Anschließend wird ein Temperaturschritt bei einer Temperatur von 550°C für 15 Minuten in einer Formiergasatmosphäre mit 4% Wasserstoff und 96% Stickstoff durchgeführt. Für das ionisierte Sputter-Verfahren ist der Widerstand auf etwa 93% und für das Standard-Sputter-Verfahren auf etwa 82% des ursprünglichen Widerstandes abgesenkt worden.

Dies bedeutet einen Vorteil des erfindungsgemäßen Temperatur-Prozeß-Verfahrens gegenüber dem Standardverfahren.

Die Temperaturprozeßabfolge P3 sieht vor, daß zunächst ein Temperaturschritt bei 550°C in wasserstoffhaltiger Atmosphäre für eine Zeitdauer von 20 Minuten durchgeführt wird. Anschließend wird ein Temperaturprozeß bei einer Temperatur von 550°C und einer Zeitdauer von 5 Minuten in einer Formiergasatmosphäre mit 4% Wasserstoff und 96% Stickstoff durchgeführt. Das Verfahren P3 führt zu einer Herabsenkung des Widerstandes auf etwa 88% für das ionisierte Sputter-Verfahren und 79% für das Standard-Sputter-Verfahren.

Die Prozeßabfolge P4 sieht vor, daß ein Temperaturschritt für eine Zeitdauer von 25 Minuten bei einer Temperatur von 550°C in wasserstoffhaltiger Atmosphäre durchgeführt wird. Dabei ergibt sich für das ionisierte Sputter-Verfahren eine Herabsenkung auf 88% und für das Standard-Sputter-Verfahren auf 78% des ursprünglichen Widerstands. Das Verfahren P4 führt allerdings keine Nitridierung der metallhaltigen Schicht 6 durch, so daß keine Nitridbarriere gebildet wird.

### Bezugszeichenliste

- 1: Substrat
- 2: Substratoberfläche
- 3: Dotiergebiet
- 4: Oberflächenbereich
- 5: isolierende Schicht
- 6: metallhaltige Schicht
- 7: Metallsilizidschicht
- 8: metall-nitrid-haltige Schicht
- 10: erste Temperatur
- 11: erste Atmosphäre
- 12: erste Zeitdauer
- 13: zweite Temperatur
- 14: zweite Atmosphäre
- 15: zweite Zeitdauer
- 16: Kontaktloch
- P1: erster Prozeß
- P2: zweiter Prozeß
- P3: dritter Prozeß
- P4: vierter Prozeß
- K1: erste Kurve
- K2: zweite Kurve

## Patentansprüche

1. Verfahren zur Kontaktierung eines Dotiergebiets eines Halbleiterbauelements mit den Schritten:
- Einbringen von Dotierstoff in ein Siliziumsubstrat (1) mit einer Substratoberfläche (2), wobei ein Dotiergebiet (3) an der Substratoberfläche (2) in dem Substrat (1) gebildet wird;
- Abscheiden und Strukturieren einer isolierenden Schicht (5) auf der Substratoberfläche (2), wobei ein Oberflächenbereich (4) des Dotiergebiets (3) freigelegt wird;
- Abscheiden einer metallhaltigen Schicht (6) auf der isolierenden Schicht (5) und dem Oberflächenbereich (4);
- Prozessieren des Substrats (1) während eines ersten Schritts in einer Prozeßkammer bei einer ersten Temperatur in einer ersten Atmosphäre, die H₂ enthält, für eine erste Zeitdauer, so daß aus einem Teil der metallhaltigen Schicht (6) und einem Teil des Dotiergebiets (3) Metallsilizid entsteht; und nachfolgend
- Prozessieren des Substrats (1) während eines zweiten Schritts bei einer zweiten Temperatur in einer zweiten Atmosphäre, die H₂ und N₂ enthält, für eine zweite Zeitdauer, um einen verbleibenden anderen Teil der metallhaltigen Schicht (6) zu Metallnitrid umzuwandeln, wobei der N₂-Anteil in der zweiten Atmosphäre größer ist als in der ersten Atmosphäre.

2. Verfahren nach Anspruch 1,
**dadurch gekennzeichnet, daß**
die erste Zeitdauer (12) kürzer ist als die zweite Zeitdauer (15).

3. Verfahren nach einem der Ansprüche 1 oder 2,
**dadurch gekennzeichnet, daß**
die metallhaltige Schicht (6) Titan, Tantal, Kobalt, Molybdän, Palladium, Platin, Nickel oder Wolfram enthält.

4. Verfahren nach einem der Ansprüche 1 bis 3,
**dadurch gekennzeichnet, daß**
die metallhaltige Schicht (6) mittels eines ionisierten Metallplasma-Verfahrens bei einer Temperatur zwischen 180°C und 220°C abgeschieden wird.

5. Verfahren nach einem der Ansprüche 1 bis 4,
**dadurch gekennzeichnet, daß**
der frei gelegte Oberflächenbereich (4) mittels einer naßchemischen Reinigung gereinigt wird.

6. Verfahren nach einem der Ansprüche 1 bis 5,
**dadurch gekennzeichnet, daß**
die metallhaltige Schicht (6) mittels eines ionisierten Metallplasma-Verfahrens bei einer Temperatur von 200°C ± 5°C abgeschieden wird.

7. Verfahren nach einem der Ansprüche 1 bis 6,
**dadurch gekennzeichnet, daß**
während des ersten Schritts das Prozessieren des Substrats (1) bei einer Temperatur von 550°C durchgeführt wird.

8. Verfahren nach einem der Ansprüche 1 bis 7,
**dadurch gekennzeichnet, daß**
während des ersten Schritts die erste Atmosphäre das Gas N₂ mit einem Anteil von weniger als 25% enthält.

9. Verfahren nach einem der Ansprüche 1 bis 8,
**dadurch gekennzeichnet, daß**
während des zweiten Schritts die zweite Atmosphäre einen Anteil von 4% H₂ und einen Anteil von 96% N₂ enthält.

10. Verfahren nach Anspruch 9,
**dadurch** gekennzeiehnet, daß
während des zweiten Schritts das Prozessieren des Substrats bei einer zweiten Temperatur von 550°C durchgeführt wird.

## Claims

1. Method for making contact with a doping region of a semiconductor component having the following steps:
- introduction of dopant into a silicon substrate (1) having a substrate surface (2), a doping region (3) being formed at the substrate surface (2) in the substrate (1);
- deposition and patterning of an insulating layer (5) on the substrate surface (2), a surface region (4) of the doping region (3) being uncovered;
- deposition of a metal-containing layer (6) on the insulating layer (5) and the surface region (4);
- processing of the substrate (1) during a first step in a process chamber at a first temperature in a first atmosphere, which contains H₂, for a first time duration, so that metal silicide is produced from a part of the metal-containing layer (6) and a part of the doping region (3); and afterward
- processing of the substrate (1) during a second step at a second temperature in a second atmosphere, which contains H₂ and N₂, for a second time duration in order to convert a remaining other part of the metal-containing layer (6) into metal nitride, the proportion of N₂ in the second atmosphere being larger than in the first atmosphere.

2. Method according to Claim 1,
**characterized in that**
the first time duration (12) is shorter than the second time duration (15).

3. Method according to either of Claims 1 or 2,
**characterized in that**
the metal-containing layer (6) contains titanium, tantalum, cobalt, molybdenum, palladium, platinum, nickel or tungsten.

4. Method according to one of Claims 1 to 3,
**characterized in that**
the metal-containing layer (6) is deposited by means of an ionized metal plasma method at a temperature of between 180°C and 220°C.

5. Method according to one of Claims 1 to 4,
**characterized in that**
the uncovered surface region (4) is cleaned by means of wet-chemical cleaning.

6. Method according to one of Claims 1 to 5,
**characterized in that**
the metal-containing layer (6) is deposited by means of an ionized metal plasma method at a temperature of 200°C ± 5°C.

7. Method according to one of Claims 1 to 6,
**characterized in that**,
during the first step, the processing of the substrate (1) is carried out at a temperature of 550°C.

8. Method according to one of Claims 1 to 7,
**characterized in that**,
during the first step, the first atmosphere contains the gas N₂ with a proportion of less than 25%.

9. Method according to one of Claims 1 to 8,
**characterized in that**,
during the second step, the second atmosphere contains a proportion of 4% H₂ and a proportion of 96% N₂.

10. Method according to Claim 9,
**characterized in that**,
during the second step, the processing of the substrate is carried out at a second temperature of 550°C.

## Revendications

1. Procédé d'établissement des contacts d'une zone dopée d'un composant à semiconducteurs, comprenant les stades dans lesquels :
- on introduit de la substance de dopage dans un substrat (1) en silicium ayant une surface (2) de substrat en formant dans le substrat (1) une zone (3) de dopage sur la surface (2) du substrat ;
- on dépose et on structure une couche (5) isolante sur la surface (2) du substrat en laissant à nu une partie (4) de surface de la zone (3) de dopage;
- on dépose une couche (6) métallique sur la couche (5) isolante et sur la partie (4) de surface ;
- on traite le substrat (1), pendant un premier stade dans une chambre de processus à une première température dans une première atmosphère qui contient du H₂ pendant une première durée de manière à créer du siliciure de métal à partir d'une partie de la couche (6) métallique et d'une partie de la zone (3) de dopage ; et ensuite
- on traite le substrat (1), pendant un deuxième stade, à une deuxième température dans une deuxième atmosphère qui contient du H₂ et du N₂ pendant une deuxième durée pour transformer une autre partie restante de la couche (6) métallique en nitrure de métal, la proportion de N₂ dans la deuxième atmosphère étant plus grande que dans la première atmosphère.

2. Procédé suivant la revendication 1, **caractérisé en ce que** la première durée (12) est plus petite que la deuxième durée (15).

3. Procédé suivant l'une des revendications 1 ou 2, **caractérisé en ce que** la couche (6) métallique contient du titane, du tantale, du cobalt, du molybdène, du palladium, du platine, du nickel ou du tungstène.

4. Procédé suivant l'une des revendications 1 à 3, **caractérisé en ce que** l'on dépose la couche (6) métallique au moyen d'un procédé au plasma de métal ionisé à une température comprise entre 180°C et 220°C.

5. Procédé suivant l'une des revendications 1 à 4, **caractérisé en ce que** l'on nettoie la partie (4) de surface laissée à nu au moyen d'un nettoyage chimique en voie humide.

6. Procédé suivant l'une des revendications 1 à 5, **caractérisé en ce que** l'on dépose la couche (6) métallique au moyen d'un procédé au plasma de métal ionisé à une température de 200°C ± 5°C.

7. Procédé suivant l'une des revendications 1 à 6, **caractérisé en ce que**, pendant le premier stade, on effectue le traitement du substrat (1) à une température de 550°C.

8. Procédé suivant l'une des revendications 1 à 7, **caractérisé en ce que** pendant le premier stade, la première atmosphère contient le N₂ gazeux en une proportion de moins de 25 %.

9. Procédé suivant l'une des revendications 1 à 8, **caractérisé en ce que**, pendant le deuxième stade, la deuxième atmosphère contient une proportion de 4% de H₂ et une proportion de 96 % de N₂.

10. Procédé suivant la revendication 9, **caractérisé en ce que**, pendant le deuxième stade, on effectue le traitement du substrat à une deuxième température de 550°C.
